(19) Europäisches Patentamt
European Patent Office
Office européen des brevets

(11) **EP 2 975 659 B1**

(12) **EUROPEAN PATENT SPECIFICATION**

(45) Date of publication and mention
of the grant of the patent:
**16.10.2019   Bulletin 2019/42**

(51) Int Cl.:
***C04B 35/01*** *(2006.01)*    ***H01L 35/22*** *(2006.01)*

(21) Application number: **14177502.3**

(22) Date of filing: **17.07.2014**

(54) **Thermoelectric generator comprising a thermoelectric element**

Thermoelektrischer Generator mit einem thermoelektrischen Element

Générateur thermoélectrique comprenant un élément thermoélectrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.01.2016   Bulletin 2016/03**

(73) Proprietor: **TDK Electronics AG**
**81671 München (DE)**

(72) Inventors:
 • **Wang, Yongli**
  **8523 FRAUENTAL (AT)**
 • **Jancar, Bostjan**
  **1000 LJUBLJANA (SI)**
 • **Grünbichler, Hermann**
  **8503 ST. JOSEF (AT)**
 • **Rinner, Franz**
  **8530 DEUTSCHLANDSBERG (AT)**
 • **Vengust, Damjan**
  **1293  SMARJE SAP (SI)**

 • **Suvorov, Danilo**
  **1000 LJUBLJANA (SI)**

(74) Representative: **Epping - Hermann - Fischer**
**Patentanwaltsgesellschaft mbH**
**Schloßschmidstraße 5**
**80639 München (DE)**

(56) References cited:
 **EP-A1- 1 672 709      JP-A- 2002 274 943**
 **JP-A- 2003 034 576      JP-A- 2003 246 678**

 • **REITMAIER C ET AL: "Transverse thermoelectric devices", APPLIED PHYSICS A; MATERIALS SCIENCE & PROCESSING, SPRINGER, BERLIN, DE, vol. 99, no. 4, 8 May 2010 (2010-05-08), pages 717-722, XP019844682, ISSN: 1432-0630**
 • **GOLDSMID H J: "Application of the Transverse Thermoelectric Effects", JOURNAL OF ELECTRONIC MATERIALS, WARRENDALE, PA, US, vol. 40, no. 5, 1 May 2011 (2011-05-01), pages 1254-1259, XP009195355, ISSN: 0361-5235**

**EP 2 975 659 B1**

**Description**

A ceramic material for a thermoelectric element, a thermoelectric element comprising the ceramic material, a thermoelectric generator comprising the thermoelectric element and a method for producing the ceramic material are described.

It is known that waste heat from modern industries and mobile engines provides a huge amount of free energy. However, the sources of waste heat disperse widely in terms of energy quantity, temperature, and carrier medium. Thermoelectric generation systems convert heat energy directly into electrical energy, and can be adapted in large scale for various sizes and temperatures of the heat source. In addition, the advantages of having no moving part, producing no environmentally deleterious wastes, and needing little maintenance, makes thermoelectric generation an attractive technology in advanced waste heat recovery systems.

The main challenge of thermoelectric generation lies on the thermoelectric materials. High efficient materials usually contain toxic and expensive elements, and are not stable in air at high temperatures. Recent researches reveal some promising oxide ceramic materials, which can be used in air up to very high temperatures, for example up to 800-1100 °C. The thermoelectric properties, however, are much lower than the non-oxide materials over wide range of temperature. Some of the ceramics need complicated and/or expensive processes like hot-press, templated grain growth, etc., and the reproducibility of the performances remains challenging.

Typically a thermoelectric generator is constituted with a number of thermocouples including a p-type and an n-type thermoelectric leg. The p-type and n-type thermoelectric legs are electrically connected in series and thermally connected in parallel, and the heat flows across the legs is partially converted into electrical power by the thermoelectric materials. The efficiency of the thermoelectric generator depends mostly on the figure of merit of the thermoelectric materials, and the design of the thermoelectric device.

The most promising p-type thermoelectric oxide ceramics are based on alkali or alkaline-earth cobaltite compounds. These materials have a special miss-fit layered structure, where rock-salt $CoO_2$ layers and other structure compounds are alternatively laminated along c-axis of the lattice, forming an incommensurate lattice along the b-axis. The electric conductivity of this structure is strongly anisotropic and is highest within the a-b plane, while the Seebeck coefficient is approximately isotropic. The interfaces between the $CoO_2$ and adjacent layers disrupt heat transfer by lattice phonons, and leads to a relatively lower thermal conductivity.

The most intensively investigated materials are $Na_xCoO_2$ and $Ca_3Co_4O_{9+\delta}$. Various approaches have been developed to prepare a textured polycrystalline ceramic with reduced thermal conductivity, of which the high figure of merit (ZT) can be expected along the texturing direction. Up to now, there has been achieved a highest ZT-value of ~0.9 (at 950K) for $Na_xCoO_2$-based, and of ~0.6 (at 1050K) for $Ca_3Co_4O_{9+\delta}$-based ceramics, respectively. However, the processing of these high performance materials is complicated, for example with templated grain growth technology to achieve textured $Na_xCoO_2$-ceramics, with polymerized complex technology to include embedded Ag-particles, in particular for lower thermal conductivity, with SPS or hot-press sintering to produce dense and textured $Ca_3Co_4O_{9+\delta}$-ceramics. The complications in ceramic processing inevitably lead to an increase in the fabrication costs and a decrease in the reproducibility and/or controllability of the properties.

Promising n-type thermoelectric properties have been revealed in modified $ZnO$, $SrTiO_3$, and $CaMnO_3$ ceramics. Generally donor dopants are incorporated into the host lattices to introduce extrinsic conductive charge carriers (electrons). The electrical conductivity and Seebeck coefficient can be greatly changed by the donor concentration and the oxygen partial pressure of the atmosphere in process. Specifically $ZnO$-based ceramics with high ZT-value (~ 0.3 at 1273K) are sintered in pure $N_2$, and $SrTiO_3$-based ceramic (ZT ~ 0.35 at 1000K) has been sintered in forming gas containing 5% $H_2$. The thermoelectric properties can easily degrade in air when the ceramics are heated to above ~ 500 °C. Donor-doped perovskite $CaMnO_3$ show stable thermoelectric properties up to 900 °C in air, and the ZT-value of more than 0.3 at 1000K has been reported.

Besides the many challenges in improving the thermoelectric properties and in the material fabrications, the low compatibility between the promising p-type and n-type ceramics further limit the applicability of the thermoelectric oxide ceramics. The figure of merit (ZT) for a thermocouple of two ceramic legs is usually appreciably lower than that of the better material. Further, the different temperature dependence of the thermoelectric properties, and different thermal expansion coefficient between the very different material systems, for example layered cobaltite and perovskites, pose more challenges in the device design and performance optimization of thermoelectric generation made out of ceramic legs. The power density and efficiency of so-far reported all-oxides thermoelectric generation modules are practically too low to compete with the non-oxides solutions. In prior art document US 2011/0226303 A1 a method of manufacturing a thermoelectric conversion element including the preparation of a plurality of p-type semiconductor sheets and a plurality of n-type semiconductor sheets is disclosed.

Document EP1672709 A1 discloses a conductive paste for connecting p-type and n-type thermoelectric conversion materials used in thermoelectric-conversion modules.

Both articles H.J. GOLDSMID: "Application of the Transverse Thermoelectric Effects" (Journal of Electronic Materials, vol. 40, no. 5, May 2011, pages 1254-1259) and REITMAIER C ET AL: "Transverse thermoelectric devices" (APPLIED PHYSICS A; MATERIALS SCIENCE & PROCESSING, vol. 99, no. 4, 8 May 2010 (2010-05-08), pages 717-722) disclose transverse thermoelectric elements.

It is an object of at least some embodiments of the invention to provide an improved thermoelectric generator.

This object is achieved by means of the subject matter of the independent patent claim 1. The dependent patent claims relate to advantageous configurations.

According to the invention, a thermoelectric generator comprises a thermoelectric element including a ceramic material. The ceramic material is based on the formula:

$$(Ca_{3-x}Na_x)CO_4O_{9-\delta} \qquad (I),$$

where x ranges from 0.1 to 2.9, and $\delta$ is a function of x which is related to the thermodynamic equilibrium of the system under processing conditions. , The base composition of the ceramic material can be formulated as $(Ca_{3-x}Na_x)CO_4O_{9-\delta}$, with $0.1 \leq x \leq 2.9$ and $0 < \delta \leq 2$. In particular, the ceramic material can be a p-type thermoelectric ceramic.

Here and in the following, the ceramic material can be referred to as the herein described ceramic material, ceramic, ceramics, thermoelectric oxide ceramics or CNC-x ceramic.

According to a preferred embodiment, the ceramic material is based on above formula (I), wherein $0.3 \leq x \leq 2.7$.

According to another preferred embodiment, the ceramic material is based on above formula (I), wherein $0 < \delta \leq 1$.

The oxide materials typically have a density of about 4-5 g/cm$^3$, which leads to a high weight-normalized efficiency (ZT/w) and is advantageous for example in automotive applications.

Furthermore, the oxide materials and thermoelectric devices made out of them can be used in ambient atmosphere up to 800°C with no risk on the materials stability, therefore a wide application scope can be expected.

In particular, the formulated compositions can be processed to form a textured, coherently intergrown bi-phase or multi-phase ceramic material. Preferably, the ceramic material contains at least two different misfit layered cobaltites, as for example (Na-modified) $Ca_3Co_4O_9$ and (Ca-modified) $Na_{0.75}CoO_2$, or other variants as for example $Na_{0.68}CoO_2$. Furthermore, the value of x is preferably selected to be out of the solubility limits of Na in $Ca_3Co_4O_9$ structure, and that of Ca in $Na_{0.75}CoO_2$, so that a single phase material is prevented.

According to another embodiment of the thermoelectric generator, the ceramic material comprises a laminate with a textured, coherently intergrown bi-phase or multi-phase structure.

For example, the texturing structure can be realized by the preferable orientation of the platelike grains, with 2-5 $\mu$m in thickness and 10-30 $\mu$m in length/width, and each platelike grain contains a laminate of the two misfit layered phases. The normal of the laminate is along the thickness direction of the grain, and is parallel to the c-axis of each phases. Preferably, the thickness of each phase layer ranges from 50 to 500 nm, and the interfaces between them are coherent to the lattices on both sides. Such a particular structure provides a nearly continuous connection of the highly conductive $CoO_2$ planes, in either phase, within the texturing plane, and a full scale phonon scattering network containing the lattice scale (~nm) misfit-layers-interface, the nanoscale (~100nm) coherent phase boundary, and the microscale (~10 $\mu$m) grain boundaries. As a result, the highest electric conductivity can be observed along the directions within the texturing plane, while the lowest electric conductivity along the directions perpendicular to the texturing plane.

According to another embodiment of the thermoelectric generator, the ceramic material comprises a figure of merit ZT which is equal to or greater than 0,15 at 950K, for example equal to or greater than 0,17 at 950K.

According to another embodiment of the thermoelectric generator, the ceramic material comprises a density between 4.0 to 5.0 g/cm$^3$.

In comparison to the single phase counterparts, $Ca_3Co_4O_9$, and/or $Na_{0.75}CoO_2$, the intergrowth structures show comparable thermoelectric properties, while the process is much easier and/or the stability is higher. Thus, high performance thermoelectric ceramic materials can be obtained in this system by optimizing the composition, microstructure, and by selecting proper orientations.

The herein described high thermoelectric performance oxide ceramics can be used in thermoelectric generators that are suitable for high temperature, for example up to 800°C, heat sources with no risk about the oxidation and evaporization of the components.

Furthermore, thermoelectric elements or thermoelectric generators comprising the herein described thermoelectric oxide ceramics are described. In particular, a thermoelectric element comprising the ceramic material is described as well as a thermoelectric generator comprising at least one such thermoelectric element.

According to an embodiment not according to the invention, the herein described oxide ceramics can be used in longitudinal thermoelectric generators with classic $\Pi$-type structure, wherein p-type legs of $(Ca_{3-x}Na_x)Co_4O_{9-\delta}$, and n-type ceramic legs, preferably a donor modified $CaMnO_3$, are thermally connected in parallel and electrically connected in series. Ag-paste can be used as the electric contact material, and $Al_2O_3$, AIN, and/or $Si_3N_4$ substrate can be used as thermal contact materials. The thermoelectric legs and the thermal contact materials are joint with Ag-paste at room temperature and co-fired at 750-850 °C to form the thermoelectric device. A high fabrication factor (F) can be achieved due to the high electric/thermal conductivity of Ag and high thermal conductivity of the ceramic substrates.

Preferably, all materials are stable against oxidation or evaporization in air up to 800 °C, and the ceramic materials (the legs and thermal contacts) density ranges from 3 to 4.5 g/cm$^3$.

According to another embodiment not according to the invention, the herein described oxide ceramic material can be used in longitudinal thermoelectric generators with "one-leg-type" thermal couples comprising one ceramic leg, of at least one of the $(Ca_{3-x}Na_x)Co_4O_{9-\delta}$ ceramics, and one metallic leg, for example of Ag, Au, Pd, Pt, their alloys or stainless steels, which are stable in air at high temperatures. The Seebeck coefficient of the metals are much lower than that of ceramics, and the electric and thermal conductivity of them are much higher. Therefore the main thermoelectric response and weight of the thermoelectric device is contributed from the ceramic legs, and the metallic legs are rather a conductor connecting the ceramic legs in series than a thermoelectric element.

The "one-leg-type" structure can be constructed with ceramic legs, metal wires, Ag-paste, and $Al_2O_3$, AlN, and/or $Si_3N_4$ substrates with co-firing procedure. A high fabrication factor, F, can be achieved due to the high electric/thermal conductivity of Ag and high thermal conductivity of the ceramic substrates.

In particular, all materials are stable against oxidation or evaporization in air up to 800 °C, and the ceramic materials (the legs and thermal contacts) density ranges from 3 to 4.5 g/cm3.

According to an embodiment, the herein described oxide ceramic material can be used in transverse thermoelectric generators with synthetic thermoelectric elements, which is constituted with one ceramic and one metallic material, of Ag, Au, Pd, Pt, their alloys or stainless steels, which are stable in air at high temperatures, which have very different electric and thermal conductivity (e.g. $\sigma_A\lambda_A >> \sigma_B\lambda_B$).

Preferably, the two materials are combined to form a 2-2 type or 1-3 type, or a hybrid composite, in order to achieve a synthetic composite with strong anisotropy of Seebeck coefficient. The thermoelectric power can be obtained along a direction perpendicular to the temperature gradient, provided that the axes of the Seebeck ellipsoid of the composite are inclined to the temperature gradient by an angle $0° < \varphi < 90°$.

According to a further embodiment, the output voltage of the element can be tuned by varying the material properties, the cross section ratio of the two materials, the inclining angle, the temperature gradient, and the aspect ratio (length/thickness) .

In particular, the composite elements can be fabricated with well-developed multilayer ceramic forming and/or co-fire technology, with controlled layers thickness, tilting angle and aspect ratio. The transverse thermoelectric generator can be constructed with as-prepared composite elements, thermal contact substrates of $Al_2O_3$, AlN, and/or $Si_3N_4$, and electric contacts. The joint between thermoelectric elements and thermal contact plates can be realized by highly thermal conductive cements, followed by proper heat treatments. The electric contacts can all be arranged in the low temperature side, and inexpensive materials like Ni, Al, Cu, or even Fe or alloys can be used.

According to another embodiment, for a certain output voltage, the number of the electric contacts can be appreciably reduced when elements of great aspect ratio are used, as leads to enhanced reliability in comparison to the longitudinal Π-type or "one-leg-type" structures.

With respect to the materials in use, thermoelectric generators with high fabrication factor, F, high temperature stability, and low weight can be achieved.

According to another embodiment not according to the invention, the herein described oxide ceramic material can be used in thermoelectric generators containing segmented p-type legs, which can be made from at least one of the $(Ca_{3-x}Na_x)Co_4O_{9-\delta}$ ceramics and one or more than one non-oxide thermoelectric materials. The segments are properly aligned so that the $(Ca_{3-x}Na_x)Co_4O_{9-\delta}$ ceramic is in contact with high temperature heat source, while the maximum temperature the non-oxide segments can see is well below their decomposition temperature or melting point. The segmented legs can be combined with other n-type ceramic legs and/or metals to form more efficient thermoelectric generators or to handle greater temperature difference.

The herein described oxide ceramic material can be used in thermoelectric generators containing a combination of ceramic-ceramic thermocouples, ceramic-metal thermocouples, transverse thermoelectric elements, and segmented p-type legs. Proper combination of different thermocouples provides more flexible solutions with respect to various heat sources and different requirement in the output power and/or voltage, and can leads to ultimate performance/cost ratio.

The described thermoelectric elements and devices, containing thermocouples of various combination of materials and elements, can also be used together with other non-oxide thermoelectric elements or devices, to form a cascade thermoelectric device. Proper combinations of the materials and devices can give rise to a maximization of the energy conversion efficiency or output power over a broader temperature interval.

Advantageously, the herein described thermoelectric elements or thermoelectric generators using at least one of the herein described ceramic materials, with optimized configuration, can provide a high efficiency of ~2% in energy conversion.

Furthermore, a method for producing the herein described ceramic material for a thermoelectric element is described.

According to an embodiment, the herein described ceramic material can be synthesised via a conventional solid state reaction route.

The raw materials of calcium carbonate, sodium carbonate, and cobalt oxide, or other types of compounds, such as oxide, hydroxide, hydrocarbonate, nitride, etc., containing these elements, can be wet-mixed thoroughly with a ball-mill. After drying, the mixture powder is calcined in air at temperatures ranging from 800 to 920 °C for 2 to 24 hours, to obtain the desired crystal structure.

Depending on the composition and quantity of the powder, a secondary milling and calcination can be conducted to improve the crystallinity of the powder.

The calcined powder can then be ground with ball-mill to reduce the particle size. Preferably, the refined powder is then granulated with small amount of binder, and pressed into parts of desired geometries (disk, cylinder, bars, plates, etc.) with a uniaxial pressure of 150-220 MPa. Cold isostatic press (up to 550 MPa) can be applied to further increase the green density of them.

The parts can then be debindered at 400-500°C to burn out the organics, and sintered at 900-1000°C for 2 to 24 hours.

Depending on the composition, flowing oxygen or high pressure oxygen atmosphere can be used to improve the densification and/or to prevent the decomposition of the ceramics.

As prepared ceramics usually have a relative density of 80-95%, and a textured structure, of which the c-axis of the crystals are preferably oriented along the uniaxial pressure direction, with coherently intergrowth structured grains. The electric conductivity along the in-(texturing) plane direction is about 5-10 times higher than that along the out-of-plane direction, while the thermal conductivity has a factor of about 2 between two directions. The best figure of merit is obtained along the in-plane direction of the texture.

At least one of the misfit layered phase can be modified by cation substitutions, such as Bi, Fe, Ni, Ba, Sr, Pb, K, Li, Cu, Zn, Sc, Y and rare earth elements like La, Ce, Nd, Sm, Dy, Ho, Gd, Eu, Er, Yb, Lu. Small amount of secondary phase like nano-Ag (or Au, Pd, Pt) particles can also be intentionally introduced, or SPS or hot press sintering techniques can be used in ceramic densification. If necessary the ratio of (Ca+Na)/Co can be adjusted to ease the material process and to enhance the thermoelectric properties. The thermoelectric properties of the textured, intergrowth bi-phase or multiphase materials can be further improved by combining of these known approaches.

Advantageously, well-developed techniques in ceramic industries, for example large scale powder process, dry-press bulk ceramic fabrication, multilayer forming technology, oxide-metal or oxide-oxide co-firing technology, can be applied in the material and device fabrication and extend the flexibility in the design and application of the here described thermoelectric elements and thermoelectric generators.

Moreover, all processes and use of the thermoelectric materials and devices are in oxidising atmosphere, which leads to cost effective solutions in waste heat recovery systems by using the disclosed materials and devices.

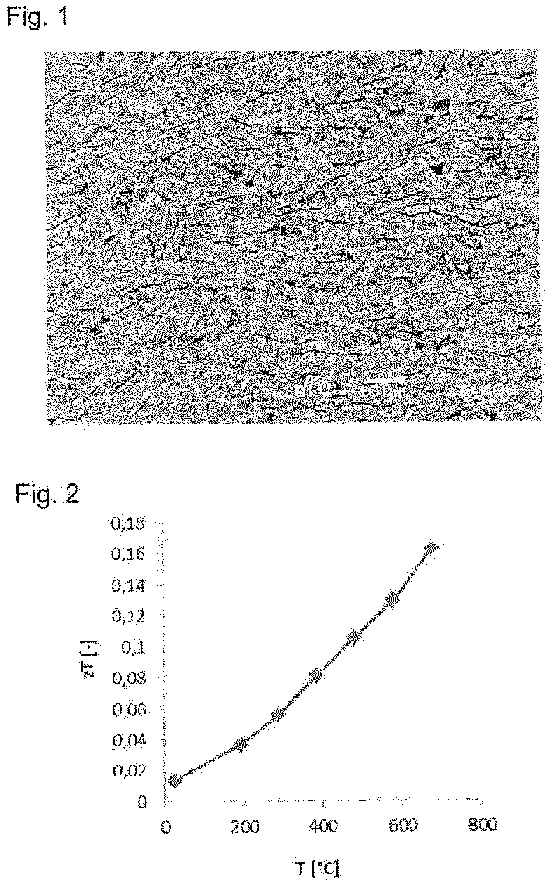

Further features, advantages and expediencies will become apparent from the following description of exemplary embodiments in conjunction with the Figures 1 to 20.

In particular, the embodiments and examples include a series of p-type thermoelectric oxide ceramics and the method for manufacturing the same as well as high temperature thermoelectric generators containing at least one of the disclosed thermoelectric ceramics.

Figure 1 shows the structure of a herein described ceramic material according to an embodiment of the thermoelectric generator.

Figure 2 shows the temperature dependence of the ZT-value of a herein described ceramic material according to a further embodiment of the thermoelectric generator.

Figure 3 shows the bi-phase microstructure of a herein described ceramic material according to a further embodiment of the thermoelectric generator.

Figure 4 shows the nano-sized bi-phase laminate structure of a herein described ceramic material according to a further embodiment of the thermoelectric generator.

Figures 5 to 9 show the electric conductivity, Seebeck coefficient, power factor, thermal conductivity and temperature dependence of the ZT-value of herein described ceramic materials according to further embodiments of the thermoelectric generator.

Figures 10 to 15 show schematic views of thermoelectric elements and/or thermoelectric generators according to further embodiments (Fig. 13 and 14 in accordance with the invention).

Figure 16 shows the temperature dependence of the ZT-value of p-type and n-type materials according to a further embodiment of the thermoelectric generator.

Figures 17 and 18 show the specific output power and energy conversion energy of thermoelectric generators according to further embodiments of the thermoelectric generator.

Figure 19 shows the preparation of a transverse thermoelectric element according to a further embodiment.

Figure 20 shows the specific Seebeck voltage and ZT of a transverse thermoelectric element as a function of the element height according to a further embodiment.

Components that are identical, of identical type and/or act identically are provided with identical reference symbols in the Figures.

First, a series of p-type thermoelectric oxide ceramics and a method for manufacturing the same are described. The main composition of these materials can be formulated as $(Ca_{3-x}Na_x)Co_4O_{9-\delta}$, where x ranges from 0.1 to 2.9, preferably from 0.3 to 2.7, and $\delta$ ranges from 0 to 2, preferably from 0 to 1. In particular, $\delta$ is a function of x and is determined by the process conditions of the ceramics. The said materials are characterized by a textured, coherently inter-growth bi-phase or multiphase polycrystalline microstructure, which corresponds to anisotropies of electrical and thermal conductivities.

Figure 1 shows a typical side view microphoto of the herein described ceramic material. In particular a textured, coherently intergrowth bi-phase structure is shown of the $(Ca_{3-x}Na_x)Co_4O_{9-\delta}$ ceramic, with x = 1.5. The back-scattering image well resolves the two-phase laminate within single grains. The dark region is $Na_xCoO_2$ based structure, while the light region is $Ca_3Co_4O_9$-based structure.

The highest figure of merit (ZT) is along the directions within the texturing plane, and its change as a function of temperature is illustrated in Figure 2 for a typical composition. In particular, Figure 2 shows the temperature dependence of the ZT-value for a $(Ca_{3-x}Na_x)Co_4O_{9-\delta}$ ceramic, with x = 0.8.

The herein described ceramic material can be processed via a cost effective way, namely with conventional solid-state-reaction route for powder synthesis, with dry-press for ceramic forming, and with normal sintering conditions for densification.

Preferably the forming of the green parts can be performed by combining a uniaxial press and a cold isostatic press, and the sintering can be conducted in oxygen flow or in high oxygen pressure chamber, in order to promote the densification or texture evolution. Well reported approaches, for example substitution, compositing, and SPS or hot-press sintering, that can improve the thermoelectric properties of the misfit layered cobaltites, can also be implemented in the disclosed system for further enhancement of the thermoelectric properties.

According to an exemplary embodiment of the ceramic material in the thermoelectric generator, a series of $(Ca_{3-x}Na_x)Co_4O_{9-\delta}$ ceramic materials (with x = 0.1, 0.3, 0.5, 0.8, 1.0, 1.5, 2.0, 2.5, and 2.9) are prepared via conventional solid state reaction route. Stoichiometric amounts of raw materials containing respective elements, for example $CaCO_3$, $Na_2CO_3$, and $Co_3O_4$, or other oxides variants, are wet-mixed thoroughly with a ball-mill, using Y-stabilized $ZrO_2$ balls and ethanol as the milling medium and agent, respectively. After drying, the mixture powder is calcined in air at temperatures ranging from 800 to 920°C for 10 hours, to obtain the desired crystal structure. A second milling and calcination are performed to achieve a more complete reaction and higher phase purity. The calcined powder is then ground with ball-mill to reduce the particle size. The refined powder is then granulated with small amount of binder, and pressed into cylinders or bars with a uniaxial pressure of 150-220 MPa. Cold isostatic press (up to 550 MPa) is then applied to further increase the green density of them. The parts are then debindered at 400-500°C to burn out the organics, and sintered at 970 to 990°C for 10 hours in a high pressure oxygen chamber ($p_{o2} \sim 10$ bar).

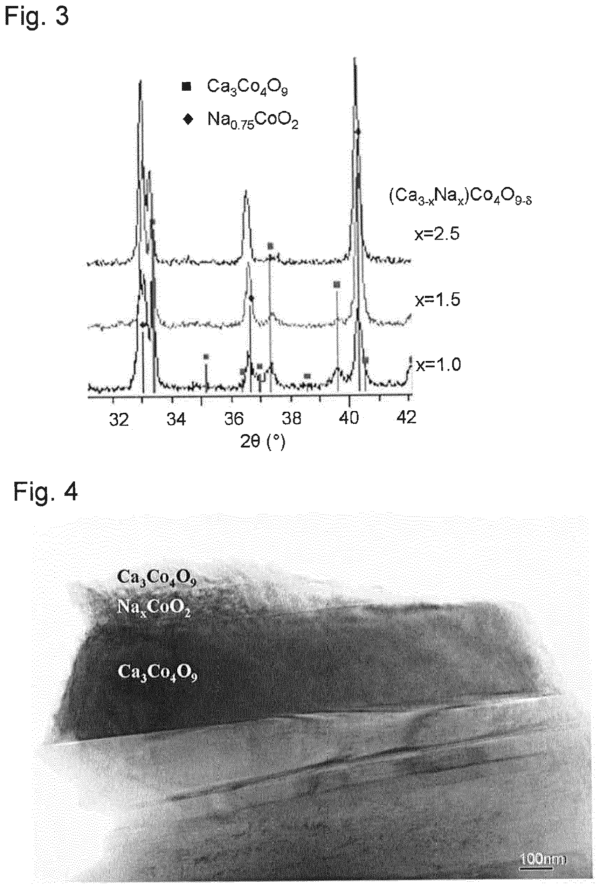

As-prepared ceramics typically have a density of 3.9-4.5 $g/cm^3$, which corresponding to a relative density of 85-95%, depends on the composition of the ceramic. Except the end member of $Na_{0.75}CoO_2$ (or x = 3.0), the densified ceramics are characterized by a bi-phase structure, and the respective fractions of each phase change with the sodium content, as shown in Figure 3, in which the bi-phase microstructure of the $(Ca_{3-x}Na_x)Co_4O_{9-\delta}$ ceramic material is shown, where higher x-value corresponds to higher content of the $Na_{0.75}CoO_2$ phase.

The textured structure evolves in the ceramics, with the c-axis of the crystal lattice preferably oriented along the uniaxial pressure. Within the plate-shaped grains, the two phases, $Ca_3Co_4O_9$ and $Na_xCoO_2$, laminate alternatively with the common c-axis normal to the interfaces. The thickness of each phase ranges from 50-500nm, and the interface between them is coherent to the lattices on both sides.

The nano-sized bi-phase laminate within one grain of a typical composition is shown in Figure 4, which shows the nano-sized bi-phase laminate within a single grain of a $(Ca_{3-x}Na_x)Co_4O_{9-\delta}$ ceramic material, with x = 0.5.

Such a microstructure enables continuous connections of the highly conductive $CoO_2$ layer between different grains and phases within the texturing plane. On the other hand, the multi-scale boundaries provide large amount of scattering centres for the phonons. As a result, highest electric conductivity can be expected along the in-plane direction of the texture, while lowest thermal conductivity can be engineered in the out-of-plane direction. The thermoelectric properties, namely electric conductivity, Seebeck coefficient, and thermal conductivity were measured along both in-plane and out-of-plane directions of the textured ceramics.

According to a further exemplary embodiment (exemplary embodiment 2 of the ceramic material in the thermoelectric generator), the same composition series are prepared as in the previous exemplary embodiment, except that the sintering is conducted in oxygen flow, or $p_{o2} \sim 1$ bar, at the same sintering temperatures and with the same dwell time. Similar density and microstructure can be achieved, and the electric properties are measured along both in-plane and out-of-plane directions of the textured ceramics.

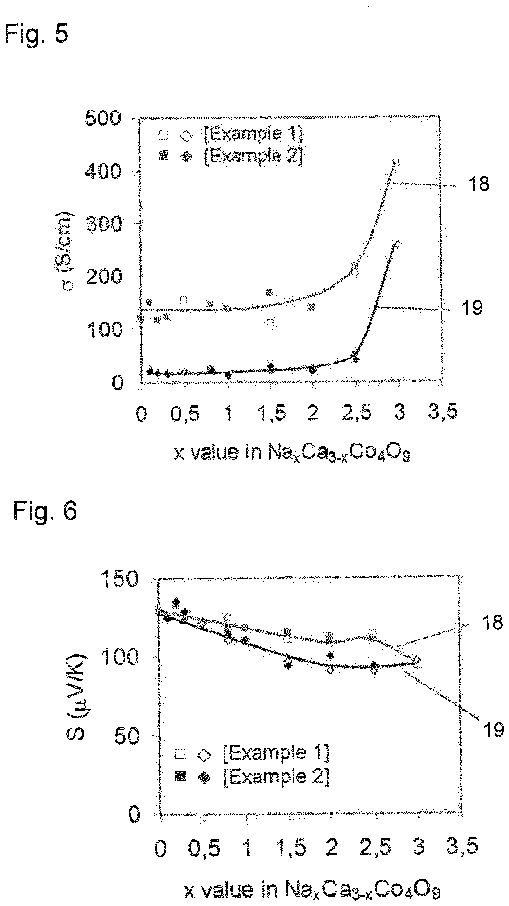

The room temperature electrical conductivities of the ceramic materials prepared in the afore mentioned examples are summarized in Figure 5, which shows the room temperature electric conductivity of the textured ceramics, sintered in high pressure chamber of $p_{o2} \sim 10$ bar of the exemplary embodiment 1, or in oxygen flow, $p_{o2} \sim 1$ bar of the exemplary embodiment 2. For the compositions with bi-phase intergrowth structure, the electrical conductivity along the in-plane direction 18 is about 5-10 times higher than that along the out-of-plane direction 19. The strong anisotropy in electrical conductivity arises from the textured microstructure where the highly conductive $CoO_2$ crystallographic planes are preferably oriented, with their normals along the uniaxial pressure, and are well connected within the texturing plane. The difference in the oxygen pressure of the sintering does not lead to a noticeable variation of the electrical conductivity for both directions.

In Figure 6 the room temperature Seebeck coefficient of the textured ceramics, sintered in high pressure chamber of $p_{o2} \sim 10$ bar of exemplary embodiment 1, or in oxygen flow, $p_{o2} \sim 1$ bar exemplary embodiment 2. Thus, in Figure 6 the Seebeck coefficients of the ceramics are summarized, and their values show very weak anisotropy despite the textured microstructure. The oxygen partial pressure in sintering also have little influence on the thermal power values for most of the bi-phase intergrowth ceramics.

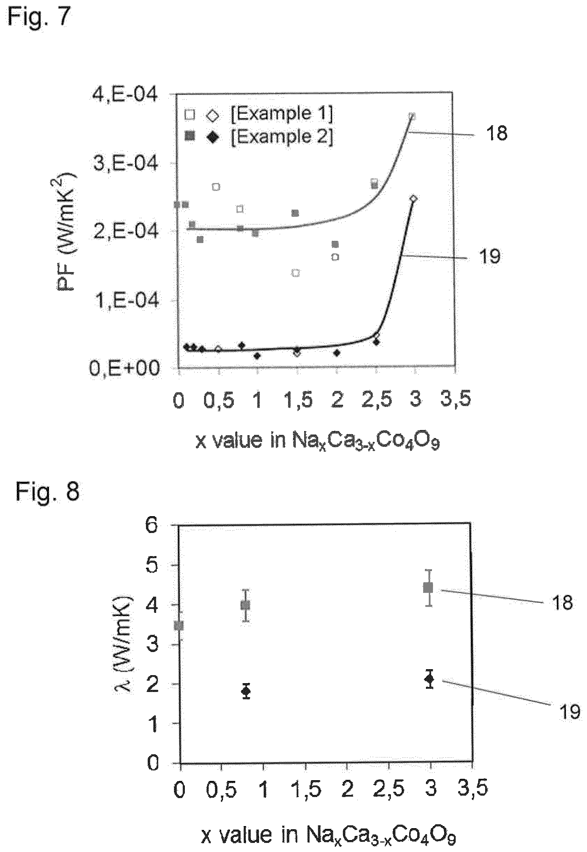

In comparison to the two single phase reference compositions, the electrical conductivity of the bi-phase intergrowth ceramics are at the same level of that of $Ca_3Co_4O_9$, while the Seebeck coefficient changes nearly linearly with the x-value. As a result, the power factor (PF, equal to $S^2\sigma$) of these materials at room temperature also show strong anisotropy, with a difference by a factor of 5-10 between the two directions, and weak composition dependence up to x = 2.5, as is illustrated in Figure 7, which shows the room temperature power factor (PF) of the textured ceramics, sintered in high pressure chamber of $p_{o2} \sim 10$ bar of exemplary embodiment 1, or in oxygen flow, $p_{o2} \sim 1$ bar of exemplary embodiment 2.

The thermal conductivity of a typical composition with bi-phase intergrowth structure is compared with the two single phase reference materials in Figure 8, which shows the room temperature thermal conductivity of a typical bi-phase intergrowth ceramic (x = 0.8) in comparison with the two reference compositions. The samples are from exemplary embodiment 1, and are sintered in high pressure chamber of $p_{o2} \sim 10$ bar.

Anisotropy is also observed between the in-plane and out-of-plane directions 18, 19, with a factor of about two. The lowest thermal conductivity is observed along the out-of-plane direction 19 for the x = 0.8 composition, which demonstrates the effectiveness of the increased scattering centers in reducing the thermal conductivity of the material. The high figure of merit can be achieved in these materials along the in-plane direction 18 of the texture.

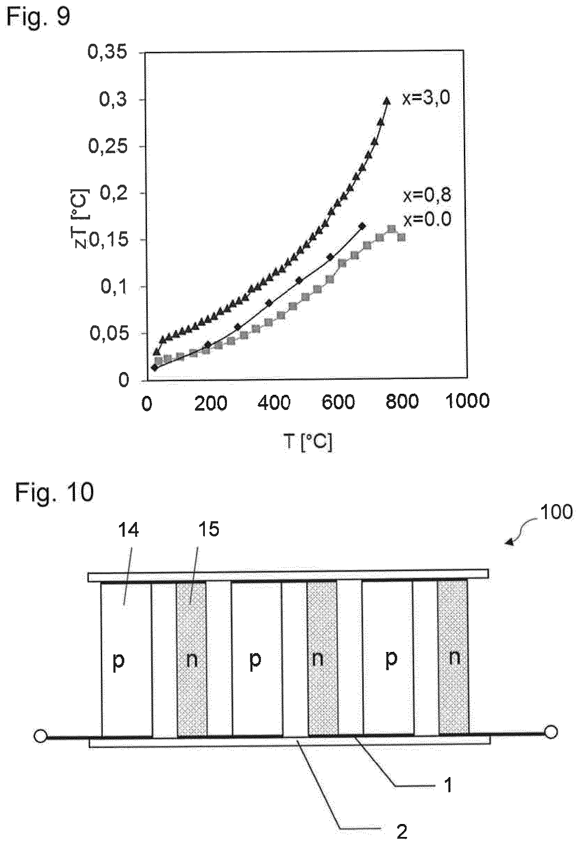

In Figure 9 the ZT value along the in-plane direction of a typical bi-phase intergrowth material is plotted as a function of temperature, and that of the reference materials are also included for a comparison. In particular, Figure 9 shows the temperature dependence of the ZT-value for a typical bi-phase intergrowth ceramic $(Ca_{3-x}Na_x)Co_4O_{9-\delta}$, with x = 0.8, and the two single phase reference materials, measured along the in-plane direction.

In the following, high temperature thermoelectric generators comprising at least one of the herein described thermoelectric ceramics are described.

In particular, high efficiency or high power density thermoelectric generators can be constructed with thermocouples and/or thermoelectric elements containing at least one of the textured bi-phase intergrowth p-type materials based on the composition $(Ca_{3-x}Na_x)Co_4O_{9-\delta}$, with $0.1 \leq x \leq 2.9$ and $0 < \delta \leq 2$. Specifically, the herein described materials (that means the ceramic materials based on $(Ca_{3-x}Na_x)Co_4O_{9-\delta}$ with $0.1 \leq x \leq 2.9$ and $0 < \delta \leq 2$) can be combined with an n-type oxide ceramic thermoelectric material of which the thermoelectric properties are stable in air at least up to 800 °C, more preferably up to 900 °C, donor doped $CaMnO_3$, for an instance, to form a conventional p-n thermocouple ("$\Pi$-type" hereafter) for longitudinal thermoelectric generators, where the heat flow is parallel or antiparallel to the electric current in the thermoelectric materials, depending on the sign of the Seebeck coefficient of respective materials.

The typical structure of a thermoelectric generator 100 containing this "$\Pi$-type" thermocouples is illustrated in Figure 10, where p-type ceramic legs 14 and n-type ceramic legs 15 are thermally connected in parallel and electrically connected in series. The p-type legs 14 are made of at least one of the herein described ceramics, i.e. based on the composition $(Ca_{3-x}Na_x)Co_4O_{9-\delta}$, with $0.1 \leq x \leq 2.9$ and $0 < \delta \leq 2$. The thermoelectric generator 100 further comprises electric contacts 1 and an insulating plate 2.

The relative dimensions between the p-legs 14 and n-legs 15 are adjusted according the materials electrical and thermal conductivities, so that the figure of merit of the thermocouple (ZT) is maximized (i.e., $\dfrac{L_n A_p}{L_p A_n} = \sqrt{\dfrac{\sigma_n \lambda_n}{\sigma_p \lambda_p}}$

) over the interesting temperature interval. The absolute sizes of them depend on the physical, thermal and electrical boundary conditions, for example the size of the available heat source, the efficiency of cooling, the output loads, etc., in order to give out usable output power. The legs 14, 15 can be in the form of rectangular bars, cylinders, plates, and so on.

The thermocouples or thermoelectric generator can be fabricated by assembling the separately prepared ceramic parts with the electric contact materials and insulating plates, or by co-firing the green parts into a monolithic multilayer laminate, provided that proper isolation is arranged between the adjacent p-type and n-type legs 14, 15.

Furthermore, the herein described materials can be combined with a metal material, which can be either n-type or p-type, and which is stable in air at least up to 800°C, more preferably up to 900°C, Ag, Au, Pd, Pt, or their alloys, stainless steels, for instances, to form a "one-leg-type" thermocouple for longitudinal thermoelectric generators. The Seebeck coefficient of the metal material is negligible in magnitude in comparison with the herein described ceramics, and the generated electric power is mainly contributed by the high performance ceramic legs.

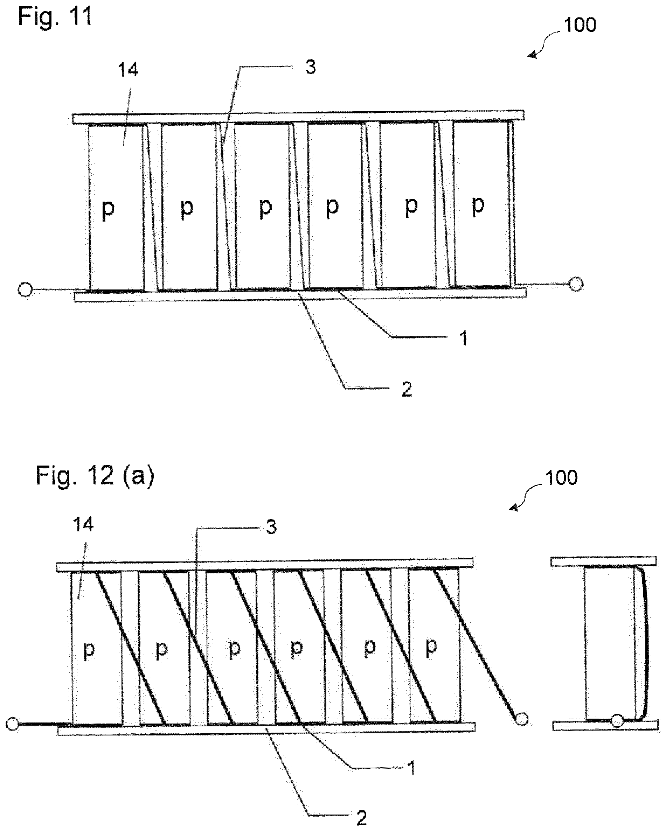

Figure 11 shows a schematic structure of a thermoelectric generator 100 containing "One-leg-type" thermocouples of a ceramic leg and a metal leg, where the ceramic leg 14 is made of at least one of the herein described ceramic material.

Again the ZT of the thermocouple is maximized by tailoring the relative dimensions of the ceramic legs (made of the herein described ceramic material) and the metal legs (i.e. $\dfrac{L_{CNC-x} A_{metal}}{L_{metal} A_{CNC-x}} = \sqrt{\dfrac{\sigma_{CNC-x} \lambda_{CNC-x}}{\sigma_{metal} \lambda_{metal}}}$ ) over the inter-

esting temperature interval.

Usually the high temperature stable metals have much higher thermal and electrical conductivities in comparison to the herein described ceramic material. Their optimal cross section area is about 2 to 3 orders of magnitude less than that of the ceramic legs. Therefore the metal legs can be made from commercially available wires, tapes, foils, strips, and so on. The ceramic legs can be in the form of rectangular bars, cylinders, plates, and so on. The "one-leg-type" thermocouples or thermoelectric generator 100 can be fabricated by assembling the separately prepared ceramic parts and the metal legs with the electric contact materials and insulating plates, or by co-firing or multilayer technology to form a monolithic multilayer laminate (like the MLCC structure), provided that proper isolation is arranged between the adjacent p-type ceramics and metal legs. Both the geometry, for example length, bending shape, etc., and the alignment, or the position with respect to the connected ceramic parts, of the metal legs can be very flexible thanks to the small cross section area and the excellent ductility of the metal materials.

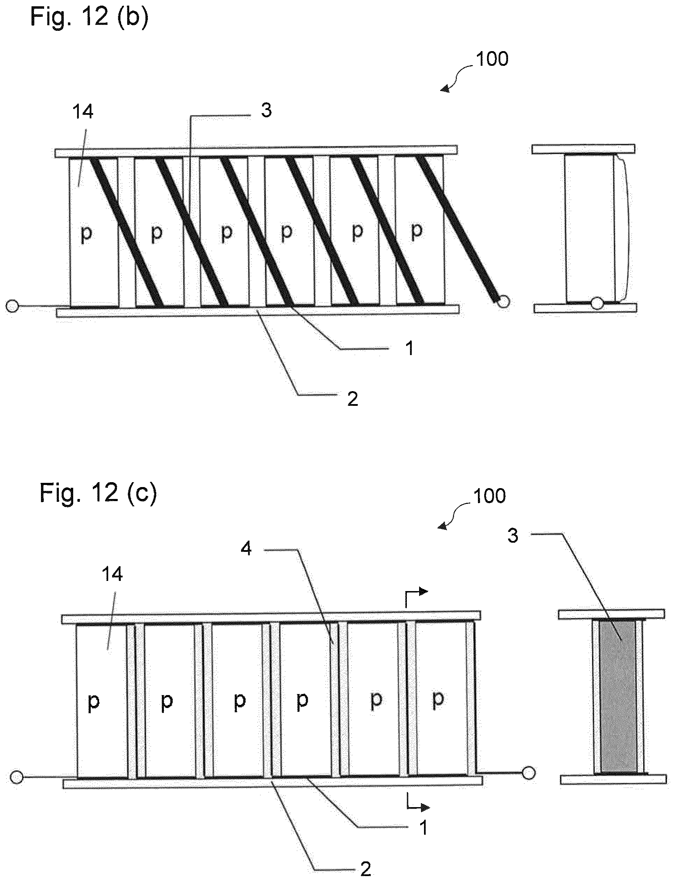

In Figure 12 (a), (b) and (c) some variants of the "one-leg-type" thermocouples constituting thermoelectric generators 100 are illustrated. The realization of this strategy can be as even different variants or as a combination of different variants within the spirit of the present invention. In particular, Figure 12 (a) shows a thermoelectric generator 100 containing "One-leg-type" thermocouples of a ceramic leg 14 and a metal wire (metal leg 3), where the wire is outside the ceramic row, Figure 12 (b) shows a thermoelectric generator 100 containing "One-leg-type" thermocouples of a ceramic leg 14 and a metal strip (metal leg 3), where the strip is outside the ceramic row, and Figure 12 (c) of a co-fired multilayer laminate, with insulating layers 4 separating the herein described ceramic material part and the metal layer.

Furthermore, the herein described materials are combined with a metal material, which can be either n-type or p-type, and which is stable in air at least up to 800 °C, more preferably up to 900 °C, Ag, Au, Pd, Pt, or their alloys, stainless steels, for instances, to form a transverse thermoelectric element, of which the generated electric current is perpendicular to the direction of temperature gradient.

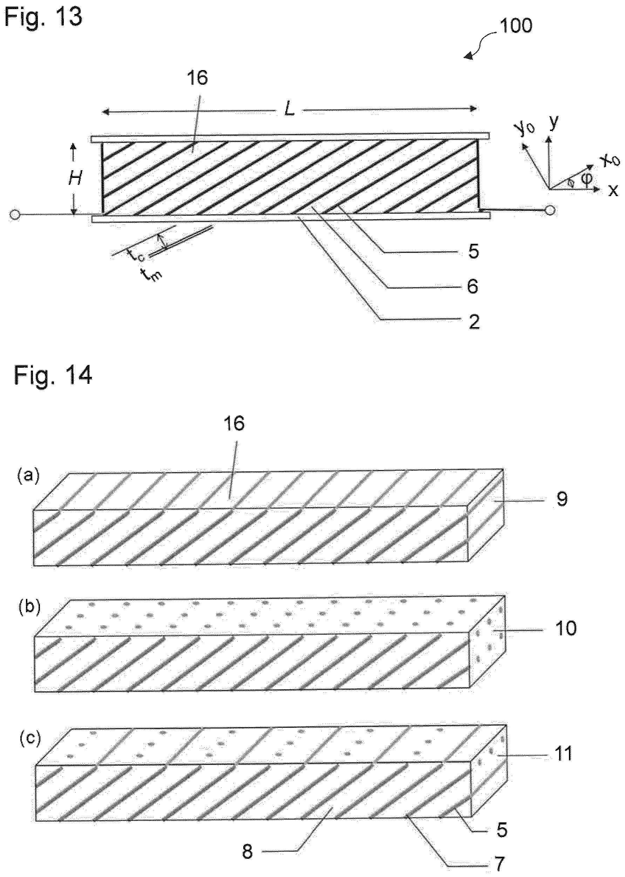

The structure of a typical transverse thermoelectric element 16 is schematized in Figure 13, which shows a schematic structure of a thermoelectric generator 100 containing a transverse thermoelectric element 16 which is constituted by at least one of the herein described ceramics and a high temperature stable metal.

In particular, the herein described ceramic material and the metal material are alternatively laminated along the $y_0$ direction to form a 2-2 composite, of which the anisotropy of the apparent Seebeck coefficient, thermal conductivity, and electrical conductivity can be engineered. The anisotropy of the thermoelectric properties depends on the materials properties, and the ratio of the cross section area, or thickness, of the two components. Generally, the metal material and its relative thickness are selected so that the inequalities of $R_c \gg R_m$, (electrical resistance) and $K_m \gg K_c$ (thermal conductance) are satisfied over the interesting temperature interval. As a consequence the apparent Seebeck coefficient along the $y_0$-direction converges to that of the herein described ceramic, while along the $x_0$-direction it is mainly controlled by that of the metal.

Transverse thermoelectric effects can be achieved using this synthetic material with anisotropic Seebeck coefficient. Provided that the direction of the temperature gradient (e.g. y-direction) is inclined by an angle of $0° < \varphi < 90°$ with respect to the laminate normal ($y_0$-direction), a transverse thermal power can be collected along the x-direction. The transverse voltage depends on the anisotropic properties of the composite, the inclining angle $\varphi$, and is in proportional to the aspect ratio of the element, L/H. The transverse figure of merit can be maximized by choosing an ultimate inclining angle $\varphi$.

The anisotropic composite for transverse thermoelectric elements is not limited to the 2-2 structure. The materials can be combined into a 1-3 structure, where some 1-dimension metal wires, strips, and fibers, rods can be embedded into the (($Ca_{3-x}Na_x)Co_4O_{9-\delta}$)-matrix, with their longitudinal direction preferably oriented. The materials can also be combined into a hybrid structure, of which the 2-2 and 1-3 composite structure are combined.

In Figure 14 some variants of the synthetic composite structure are presented. The optimization of their properties follows the same role as for the 2-2 structure. In particular, Figure 14 shows three variants of the structure of transverse thermoelectric elements 16, which in Figure 14(a) is a 2-2 structure, in Figure 14(b) a 3-1 structure, and in Figure 14(c) a hybrid of 2-2 and 3-1 structures.

Furthermore, the herein described materials can be combined with one or more than one type of non-oxide p-type thermoelectric materials, to form a segmented p-type leg. The segments can be properly aligned so that the herein described ceramics are in contact with the high temperature source (up to 800°C), and the maximum temperature the non-oxide materials can see is well below their decomposition or melting temperature in air.

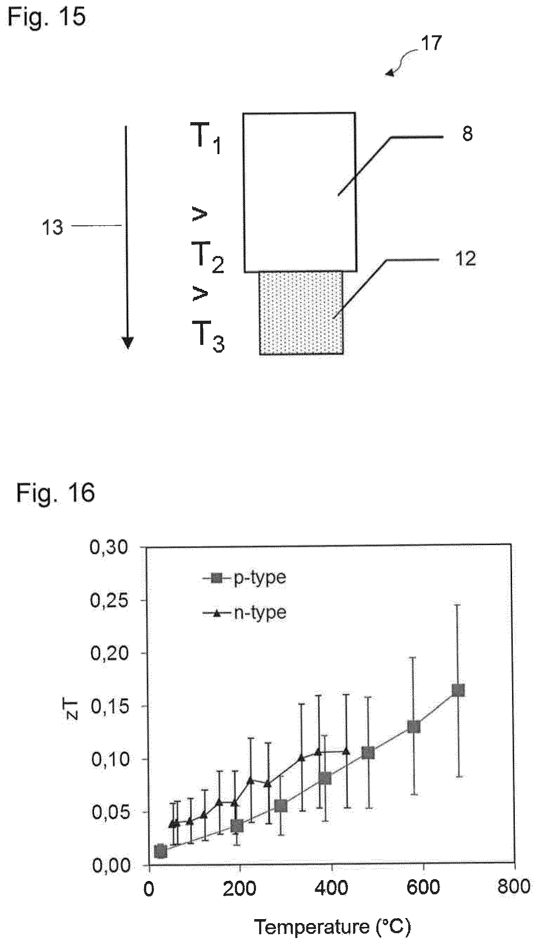

A scheme of the segmented p-type thermoelectric leg is illustrated in Figure 15, which shows a schematic structure of a segmented p-type thermoelectric leg 17, containing at least one of the herein described ceramics 8 and a non-oxide material 12. The herein described ceramic 8 is in contact with high temperature heat source, while the non-oxide material 12 to the cold heat sink. The maximum temperature that the non-oxide 12 can see is below the destabilization temperature of this material.

Specifically, the length and cross section area of respective materials are selected according to the material properties and the boundary conditions, in order to properly distribute the temperature so that the maximum temperature of the non-oxide segment, $T_2$, is lower than the maximum temperature it can withstand. The segmented p-type thermoelectric leg can be further combined with other n-type legs or metal materials to form longitudinal thermoelectric generator elements.

Furthermore, different types of thermocouples or transverse thermoelectric elements, or a combination of at least two of them, can be used to build thermoelectric generator components or devices which are suitable in working with high temperature heat sources. Further, the high temperature thermoelectric generator can be integrated into a cascade structured system which is desirable for dealing with even greater temperature difference and for high efficiency energy conversion.

According to a further exemplary embodiment (exemplary embodiment 3, not according to the invention), a longitudinal thermoelectric generator constructed with "Π-type" thermocouples is prepared.

The thermocouple contains two ceramic materials: a p-type ceramic based on ($Ca_{3-x}Na_x)Co_4O_{9-\delta}$, with x = 0.8), and an n-type based on ($La_{0.03}Ca_{0.97})MnO_3$.

The fabrication of the p-type legs is the same as in exemplary embodiment 1, but the geometry of the parts is controlled by dry press and sintering. Specifically, the sintered parts are rectangular cylinder of 10mm in length, 8mm in width and 4.5mm in thickness. The uniaxial pressure is applied along the thickness direction so that the texture plane is in parallel with the longitudinal direction.

The fabrication of the n-type legs is via a conventional bulk ceramic process route. The stoichiometric amounts of the raw materials, $La_2O_3$, $CaCO_3$, and $Mn_3O_4$, are first ball-milled to form a fine and homogeneous mixture. After-drying the raw mixture is calcined in air at 1100 °C for 6h to complete the solid state reactions. The composed powder is ground by ball-mill to refine the particle size. Around 3wt% of binder Optapix is introduced into the powder, followed by granulation and dry pressing. The green parts are debindered at 450 °C to remove the organic components, and then sintered at 1150 °C for 15h to achieve a dense and uniform structure.

The geometry of the green parts is controlled so that the sintered compacts have dimensions of 10 x 8 x 4.5mm$^3$.

The figures of merit of the n-type and p-type materials are plotted as a function of temperature in Figure 16, which shows the temperature dependence of the ZT-values of the p-type and n-type materials used in the "Π-type" longitudinal thermoelectric generator presented in the exemplary embodiment 3.

The p-type and n-type legs are alternatively aligned with their 10mm edge along the vertical direction, as illustrated in Figure 10. Such an alignment also brings about the highest figure of merit of the thermocouple over the interesting temperature interval, i.e. from 100 to 700 °C. The gap between them is 1mm, which corresponds to a filling factor of ~68%. A high temperature Ag-paste is applied to the terminates of the legs, and joint the legs and the insulating plates (0.6mm-thick-$Al_2O_3$-substrate) to form both the electric contacts between adjacent thermoelectric legs, and thermal contacts between thermoelectric legs and the alumina plates. The assembly is then dried at 150 °C for 30min, and fired at 750 °C for 15min to densify the Ag-paste and strengthen the electrical and thermal contacts.

Typically, the Ag layer has a thickness of 5-10μm, and the contact resistance is negligible in comparison to the ceramic resistances. The fabrication factor, which summarizes the influences of the electric contact and thermal contact materials on the device performances, of such an assembly can be more than 90%, according to the thermal and electric properties of the selected materials.

Such a prepared thermoelectric module can be used to handle high temperature heat sources up to 700°C with large temperature gradient, with no risk of decomposition and volatilization of the thermoelectric elements in ambient atmosphere.

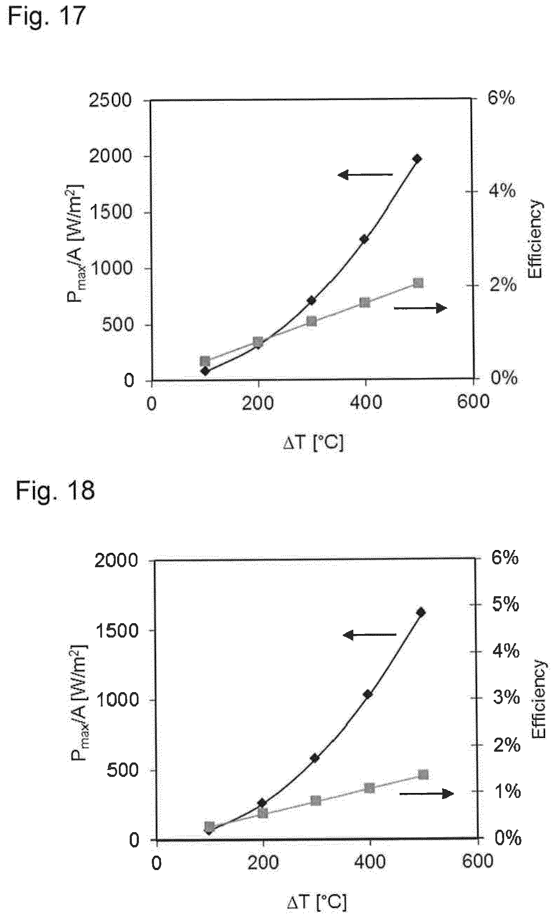

In Figure 17 the specific output power and energy conversion efficiency of the "Π-type" longitudinal thermoelectric generator presented in the exemplary embodiment 3 are plotted as a function of the temperature difference, where the mean temperature of the legs is fixed at 400°C. For a temperature difference of 500°C ($T_1$=650 °C and $T_2$=150 °C, respectively), the output power density exceeds 1950W/m$^2$ and the efficiency reaches 2.1%.

According to a further exemplary embodiment (exemplary embodiment 4 not according to the invention), a longitudinal thermoelectric generator constructed with "one-leg-type" thermocouples is prepared.

The thermocouple contains a p-type ceramic based on $(Ca_{3-x}Na_x)Co_4O_{9-\delta}$ with x = 0.8, and Ag-wire, which is also a p-type thermoelectric material but with very low Seebeck coefficient of a few $\mu$V/K.

The fabrication and geometry control of the p-type legs is the same as in exemplary embodiment 3. A commercially available Ag wire of 0.2mm in diameter is used together to form the "one-leg-type" thermocouple. Such a difference in the cross section area of the two materials leads to maximal figure of merit over the interesting temperature interval, i.e. from 100 to 700 °C.

The thermoelectric generator is constructed according to the structure illustrated in Figure 12 (a), with the Ag-paste as the electric contact and two 0.6mm-thick-$Al_2O_3$ substrates as the insulating plates. The gap between the ceramic legs is 1mm, which brings about a filling factor of ~73%. The assembling and co-firing procedure are the same as in exemplary embodiment 3, and the fabrication factor can be higher than that for the "Π-type" generator, due to the lower apparent thermal conductivity of the thermocouple, and the absence of the thermal-mismatch, i.e. the difference in thermal expansion coefficient of the two legs, between two ceramic legs, which leads to improved contact joints between the insulating plates and the thermoelectric legs.

Such prepared thermoelectric module can be used to handle high temperature heat sources up to 700 °C with large temperature gradient, with no risk of decomposition and volatilization of the thermoelectric elements in ambient atmosphere. In addition, the "one-leg-type" thermoelectric generator is advantageous in withstanding greater temperature difference due to the excellent ductility of Ag-wire.

In Figure 17 the specific output power and energy conversion efficiency are plotted as a function of the temperature difference, where the mean temperature of the legs is fixed at 400°C. For a temperature difference of 500°C ($T_1$=650°C and $T_2$=150°C, respectively), the output power density reaches 1610W/m$^2$ and the efficiency reaches 1.4%.

Figure 18 shows the specific output power and energy conversion energy of the "One-leg-type" longitudinal thermoelectric generator presented in exemplary embodiment 4, as a function of the temperature difference with fixed mean temperature of 400 °C.

According to another exemplary embodiment (exemplary embodiment 5), a transverse thermoelectric element is prepared with a p-type ceramic based on $(Ca_{3-x}Na_x)Co_4O_{9-\delta}$ with x = 0.8, and Ag via a co-firing procedure.

The fabrication of this ceramic is the same as in exemplary embodiment 1, except that the geometry is controlled to obtain a number of plates of 8x8x0.5mm$^3$. The uniaxial pressure is applied along the thickness (0.5mm) direction so that the texture is evolved within the main plane (8x8mm$^2$) of the plate. An inclined laminate is constructed with the plates and a high temperature Ag-paste.

First, the Ag-paste is printed on one of the main sides of the ceramic plates. Second, 100 pieces of the one-side printed plates are laminated into a stack, wherein the adjacent ceramic plates are separated with a layer of Ag.

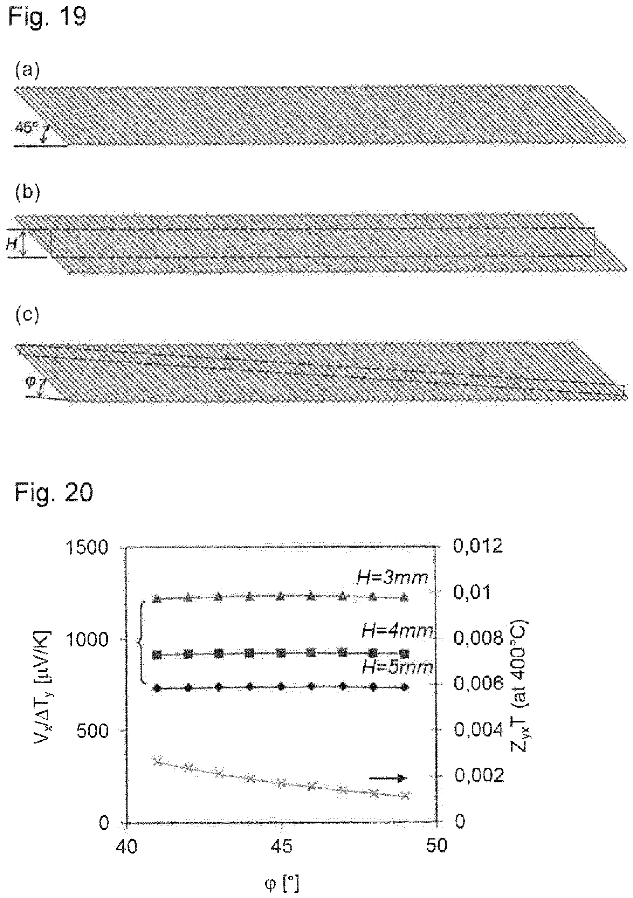

The outline of the stack is inclined by 45° with respect to the normal of the plates, as shown in Figure 19, which shows the preparation of the transverse thermoelectric element with the ceramic based on $(Ca_{3-x}Na_x)Co_4O_{9-\delta}$ with x = 0.8 and Ag paste in Figure 19(a), and subsequent machining to achieve desired thickness in Figure 19(b) and adjusting the tilting angle in Figure 19(c).

Third, the stack is dried at 150 °C for 30min, and fired at 750 °C for 15min to form a strong multilayer monolithic. The thickness of the sintered Ag-layer is 5$\mu$m.

Forth, the two zig-zag sides the stack is ground to achieve two flat and parallel surfaces to ease the thermal contacting. The thickness of the element (T, see Figure 13) can be controlled by grinding to a desired value, and the inclining angle ($\varphi$) can be slightly adjusted for refined control, as illustrated in Figures 19 (b) and (c).

The tilting angle of 45° leads to highest transverse Seebeck coefficient. In the case of the current example, the $S_{xy}$ is about $S_{CNC-0.8}/2$ when L/H=1 (with CNC-x standing for $(Ca_{3-x}Na_x)Co_4O_{9-\delta}$). The output voltage can be enlarged by increasing the aspect ratio L/H of the element.

Figure 20 shows the specific Seebeck voltage and apparent figure of merit of the transverse thermoelectric element as a function of element height H, and the inclining angle, $\varphi$, at around 400°C. In particular, the apparent thermopower and figure of merit of the transverse element are plotted as a function of the inclining angle when T~400°C.

Around 45°, the specific voltage is mainly controlled by the height of the element for a defined L~50mm like in this example, while the ZT-value strongly decreases with φ.

Here, all the thermoelectric properties of the included ceramics were measured in air. The electrical conductivity and Seebeck coefficient were measured on bars of 10-40mm in length. Four-probe method were applied to determine the resistance of part. The thermal power was evaluated by probing the voltage drop in response to a given temperature difference (~10K) at certain temperatures. The thermal conductivity was measured on plates of 10x10x1 mm$^3$, with a laser flash method in IPM, Fraunhofer Institute, Freiburg. Generally, the uncertainty of the electrical conductivity, thermal conductivity, and Seebeck coefficient are about 10%, 10%, and 7%, respectively. The calculated figure of merit has a typical uncertainty of 30-50%.

The ceramic material, the thermoelectric element comprising the ceramic material and the method for producing the ceramic material according to the embodiments shown in the Figures may additionally or alternatively comprise features or combinations of features as described above in the general part.

References

| | |
|---|---|
| 1 | electric contacts |
| 2 | insulating plate |
| 3 | metal leg |
| 4 | insulating layer |
| 5 | metal layer |
| 6 | CNC-x ceramic layer |
| 7 | metal line |
| 8 | CNC-x ceramic |
| 9 | 2-2 structure |
| 10 | 1-3 structure |
| 11 | hybrid structure |
| 12 | non-oxide material |
| 13 | heat flow |
| 14 | p-type leg |
| 15 | n-type leg |
| 16 | transverse thermoelectric element |
| 17 | segmented p-type leg |
| 18 | in-plane direction |
| 19 | out-of-plane direction |
| 100 | thermoelectric generator |

**Claims**

1. A thermoelectric generator (100) comprising a thermoelectric element including a ceramic material (8) based on the formula

$$(Ca_{3-x}Na_x)Co_4O_{9-\delta}$$

with $0.1 \leq x \leq 2.9$ and $0 < \delta \leq 2$,
wherein the ceramic material is combined with a metal material so that the thermoelectric element forms a transverse thermoelectric element.

2. The thermoelectric generator (100) according to claim 1, wherein the metal material comprises Ag, Au, Pd, Pt or their alloys.

3. The thermoelectric generator (100) according to one of claims 1 and 2, wherein the metal material is formed as a metal wire, a metal strip, a metal fiber, a metal rod or a metal layer and wherein the metal material is embedded in the ceramic material.

4. The thermoelectric generator (100) according to one of claims 1 to 3, wherein the metal material is co-fired with the ceramic material.

5. The thermoelectric generator according to one of claims 1 to 4, wherein $0.3 \leq x \leq 2.7$.

6. The thermoelectric generator according to one of the claims 1 to 5, wherein $0 < \delta \leq 1$.

7. The thermoelectric generator according to one of the claims 1 to 6, wherein the ceramic material comprises a laminate with a textured, coherently intergrown bi-phase or multi-phase structure.

8. The thermoelectric generator according to one of the claims 1 to 7, wherein the ceramic material comprises a density between 4.0 to 5.0 g/cm$^3$.

**Patentansprüche**

1. Thermoelektrischer Generator (100), umfassend ein thermoelektrisches Element, das ein Keramikmaterial (8) auf der Grundlage der Formel

$$(Ca_{3-x}Na_x)Co_4O_{9-\delta}$$

mit $0,1 \leq x \leq 2,9$ und $0 < \delta \leq 2$
enthält, wobei das Keramikmaterial mit einem Metallmaterial kombiniert ist, so dass das thermoelektrische Element ein transversales thermoelektrisches Element bildet.

2. Thermoelektrischer Generator (100) gemäß Anspruch 1, wobei das Metallmaterial Ag, Au, Pd, Pt oder deren Legierungen umfasst.

3. Thermoelektrischer Generator (100) gemäß einem der Ansprüche 1 und 2, wobei das Metallmaterial als Metalldraht, Metallstreifen, Metallfaser, Metallstab oder Metallschicht gestaltet ist und wobei das Metallmaterial in dem Keramikmaterial eingebettet ist.

4. Thermoelektrischer Generator (100) gemäß einem der Ansprüche 1 bis 3, wobei das Metallmaterial zusammen mit dem Keramikmaterial gebrannt ist.

5. Thermoelektrischer Generator gemäß einem der Ansprüche 1 bis 4, wobei $0,3 \leq x \leq 2,7$.

6. Thermoelektrischer Generator gemäß einem der Ansprüche 1 bis 5, wobei $0 < \delta \leq 1$.

7. Thermoelektrischer Generator gemäß einem der Ansprüche 1 bis 6, wobei das Keramikmaterial ein Laminat mit einer texturierten, kohärent verwachsenen zweiphasigen oder mehrphasigen Struktur umfasst.

8. Thermoelektrischer Generator gemäß einem der Ansprüche 1 bis 7, wobei das Keramikmaterial eine Dichte von zwischen 4,0 und 5,0 g/cm$^3$ aufweist.

**Revendications**

1. Générateur thermoélectrique (100) comprenant un élément thermoélectrique comprenant un matériau céramique (8) basé sur la formule

$$(Ca3-xNax)Co4O9-\delta$$

avec $0,1 \leq x \leq 2,9$ et $0 < \delta \leq 2$,
dans lequel le matériau céramique est combiné à un matériau métallique de sorte que l'élément thermoélectrique forme un élément thermoélectrique transversal.

2. Générateur thermoélectrique (100) selon la revendication 1, dans lequel le matériau métallique comprend Ag, Au, Pd, Pt ou leurs alliages.

3. Générateur thermoélectrique (100) selon l'une quelconque des revendications 1 et 2, dans lequel le matériau métallique est sous la forme d'un fil métallique, d'une bande métallique, d'une fibre métallique, d'une tige métallique ou d'une couche métallique et dans lequel le matériau métallique est inclus dans le matériau céramique.

4. Générateur thermoélectrique (100) selon l'une des revendications 1 à 3, dans lequel le matériau métallique est cocuit avec le matériau céramique.

5. Générateur thermoélectrique selon l'une des revendications 1 à 4, dans lequel $0,3 \leq x \leq 2,7$.

6. Générateur thermoélectrique selon l'une des revendications 1 à 5, dans lequel $0 < \delta \leq 1$.

7. Générateur thermoélectrique selon l'une des revendications 1 à 6, dans lequel le matériau céramique comprend un stratifié ayant une structure texturée à phase double ou multiple et à intercroissance cohérente.

8. Générateur thermoélectrique selon l'une des revendications 1 à 7, dans lequel le matériau céramique comprend une densité entre 4,0 et 5,0 g/cm3.

## Fig. 1

## Fig. 2

## Fig. 3

## Fig. 4

## Fig. 5

## Fig. 6

Fig. 7

Fig. 8

Fig. 9

Fig. 10

Fig. 11

Fig. 12 (a)

Fig. 12 (b)

100

14

3

p p p p p p

1

2

Fig. 12 (c)

100

3

14

4

p p p p p p

1

2

## Fig. 13

## Fig. 14

Fig. 15

Fig. 16

Fig. 17

Fig. 18

Fig. 19

(a)

45°

(b)

H

(c)

φ

Fig. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110226303 A1

- EP 1672709 A1

**Non-patent literature cited in the description**

- **H.J. GOLDSMID.** Application of the Transverse Thermoelectric Effects. *Journal of Electronic Materials,* May 2011, vol. 40 (5), 1254-1259

- **REITMAIER C et al.** Transverse thermoelectric devices. *APPLIED PHYSICS A; MATERIALS SCIENCE & PROCESSING,* 08 May 2010, vol. 99 (4), 717-722